# FASCICULE DE BREVET EUROPEEN

(11) **EP 3 961 924 B1**
(45) Date de publication et mention de la délivrance du brevet: **23.09.2026**
(21) Numéro de dépôt: 21193127.4
(22) Date de dépôt: 25.08.2021
(51) Int. Cl.: H03K 17/74, H03K 17/30

(54) **DISPOSITIF DE COMMANDE D'UNE DIODE OFT**
VORRICHTUNG ZUR STEUERUNG EINER OFT-DIODE
DEVICE FOR CONTROLLING AN OFT DIODE

(30) Priorité: 28.08.2020 FR 2008791
(43) Date de publication de la demande: 02.03.2022
(73) Titulaire: STMicroelectronics (Tours) SAS, 37100 Tours (FR)
(72) Inventeur: GAUTIER, Frederic, 37380 Monnaie (FR)
(74) Mandataire: Cabinet Beaumont

(56) Documents cités:
- EP-A2- 1 133 048
- DE-A1- 10 336 237
- US-A1- 2016 380 554
- US-A1- 2019 372 476
- US-B1- 10 333 425

## Description

### Domaine technique

La présente description concerne de façon générale les circuits électroniques, et plus particulièrement un dispositif de commande d'une diode commandable telle qu'une diode OFT ("Oxide Field Trench" - tranchée de champ en oxyde).

### Technique antérieure

La figure 1 est une reproduction de la figure 1 de la demande de brevet publiée US2020105946. La figure 1 représente un exemple de diode OFT 10.

La diode 10 comprend un substrat semiconducteur 20, par exemple en silicium. La diode 10 comprend une borne de cathode K, par exemple connectée électriquement à une face inférieure du substrat, et une borne d'anode A. La diode 10 comprend des tranchées 22 s'étendant dans le substrat 20 à partir de la face supérieure du substrat 20. Les tranchées 22 sont par exemple régulièrement espacées, et par exemple parallèles entre elles ou en forme d'anneaux concentriques.

La diode 10 comprend des structures 30A, décrites ci-après, situées chacune dans une tranchée 22, par exemple deux structures 30A de part et d'autre de la diode 10. De préférence, entre les structures 30A, la diode 10 comprend en outre une ou plusieurs structures 30.

Chaque structure 30 comprend, dans la tranchée 22 concernée, une région électriquement conductrice 302 située dans une partie supérieure de la tranchée 22. La région 302 est disjointe des parois de la tranchée 22, c'est-à-dire du substrat 20, et est par exemple séparée des parois de la tranchée 22 concernée par une ou plusieurs couches diélectriques 304, disposées de part et d'autre de la région 302. La région 302 et les parois de la tranchée 22 concernée sont séparées d'une distance d faible, de préférence inférieure à 10 nm, par exemple inférieure à 7 nm.

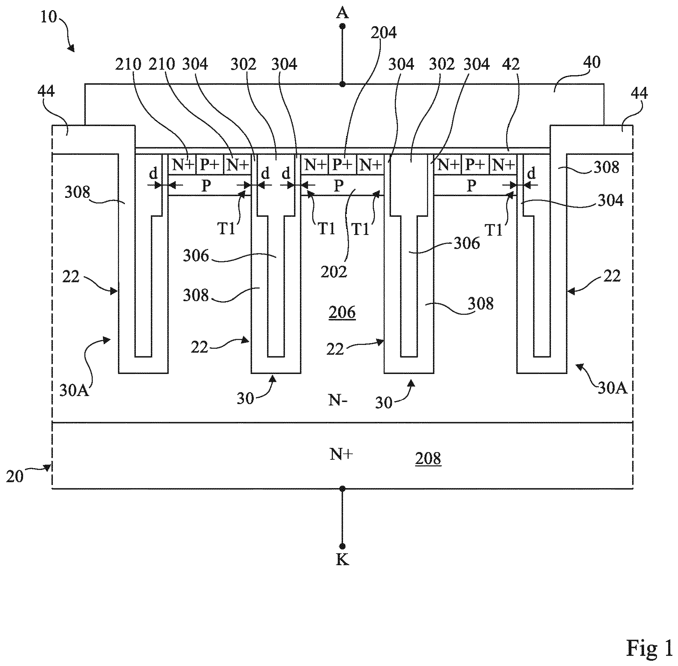

Chaque structure 30 comprend en outre une région électriquement conductrice 306 s'étendant dans la tranchée, plus bas (ou plus profondément) que la région 302. Dans l'exemple illustré en figure 1, les régions 302 et 306 sont d'une seule pièce, bien que, en variante, les deux régions 302 et 306 puissent être disjointes et isolées électriquement l'une de l'autre par une ou plusieurs couches diélectriques, les deux régions 302 et 306 s'étendant alors depuis la face supérieure du substrat 20.

La région 306 est par exemple située plus loin des parois de la tranchée 22 que la région 302. La région 306 est par exemple séparée du substrat 20 par une ou plusieurs couches diélectriques 308 recouvrant les parois et le fond de la tranchée 22. L'épaisseur de la couche 308 est par exemple supérieure à environ 100 nm, de préférence comprise entre 250 nm et 1000 nm.

Les structures 30A reprennent les mêmes éléments que les structures 30. Toutefois, dans les structures 30A, la distance d mentionnée ci-dessus est absente du côté extérieur de la diode 10. A titre d'exemple, la couche 308 se prolonge alors entre la région 302 et la paroi de la tranchée 22 concernée, du côté extérieur de la diode 10. La couche 308 peut rejoindre une couche isolante 44 recouvrant le substrat sur la périphérie de la diode.

A titre d'exemple, les régions 302 et 306 sont en silicium polycristallin dopé, et les couches 304 et 308 sont en oxyde de silicium.

Un transistor T1 peut être formé dans la partie du substrat 20 en contact de chaque couche 304, la région 302 considérée formant la grille du transistor T1. A titre d'exemple, les transistors T1 sont à canal N. Chaque transistor T1 comprend une région de canal 202 (P) dopée de type P. A titre d'exemple, chaque région de canal 202 s'étend entre deux tranchées 22 voisines et est ainsi commune à deux transistors T1 voisins. De préférence, chaque région 202 a une région centrale surmontée d'une prise de contact 204 (P+), plus fortement dopée de type P que la région 202.

Chaque transistor T1 comprend en outre une région de drain 206 (N-) située sous la région de canal 202. A titre d'exemple, chaque région de drain 206 s'étend entre deux tranchées 22 voisines et est commune aux transistors T1 voisins. Les régions de drain 206 peuvent se prolonger sous les tranchées 22, et peuvent alors se rejoindre sous les tranchées 22. Les régions 206 sont par exemple sur et en contact avec une région de prise de contact 208 (N+) s'étendant en partie inférieure du substrat 20 et étant reliée électriquement à la borne K.

Chaque transistor T1 comprend en outre une région de source 210 (N+), de préférence située contre la couche 304. La région de source 210 est par exemple plus fortement dopée de type N que la région de drain 206.

Dans la diode 10, les régions de grille 302, les régions de source 210, et les régions de prise de contact 204 des transistors T1 sont de préférence reliées électriquement à la borne d'anode A. Ainsi, la diode 10 est définie par un ou plusieurs transistors T1. Pour cela, à titre d'exemple, une couche conductrice 40, reposant éventuellement sur une couche d'interface 42, recouvre le substrat 20 et les tranchées 22. Les régions 302 et 306 s'étendent dans les tranchées 22 à partir de la couche 40 ou de l'éventuelle couche d'interface 42.

Ainsi, en figure 1, la diode OFT 10 comprend plusieurs structures 30A et éventuellement 30. Chaque structure 30A, 30 comprend, dans la tranchée 22 concernée, la région conductrice 302 séparée du substrat 20 par la distance d inférieure à environ 10 nm, et la région conductrice 306 s'étendant plus profondément dans le substrat 20 que la région 302. La diode 10 est définie par un ou plusieurs transistors T1 dont au moins une région de canal 202 s'étend entre deux des tranchées 22. Les régions 302 définissent les grilles des transistors T1 de la diode 10, c'est-à-dire une grille de la diode 10. La diode 10 comprend une région de prise de contact 204 reliant électriquement la région de canal 202 de chaque transistor T1 de la diode 10 à une couche conductrice 40 d'anode.

Une diode OFT, par exemple la diode 10 décrite en relation avec la figure 1, présente un faible courant de fuite en inverse et une faible chute de tension en direct, lorsqu'elle est convenablement commandée via un potentiel de grille. Cela fait de la diode OFT une bonne candidate pour remplacer des transistors MOS commandés en rectification synchrone ou des diodes non commandables (sans grille) dans des applications où l'on vise des courants en inverse aussi faibles que possible et des chutes de tensions en direct aussi faibles que possible, par exemple dans des applications de puissance. Le document EP 1 133 048 A2 décrit un exemple d'un transistor MOS commandé en rectification synchrone.

### Résumé de l'invention

Il serait souhaitable de disposer d'un dispositif de commande d'une diode OFT palliant tout ou partie des inconvénients des dispositifs connus de commande d'une diode OFT.

Il serait également souhaitable de disposer d'un dipôle comprenant une diode OFT et un dispositif de commande de la diode OFT palliant tout ou partie des inconvénients des dispositifs de commande connus des diodes OFT. En effet, un tel dipôle permettrait, par exemple, de remplacer une diode non commandable d'un circuit par ce dipôle, sans modifications supplémentaires du circuit.

Un mode de réalisation pallie tout ou partie des inconvénients des dispositifs connus de commande d'une diode OFT.

Un mode de réalisation prévoit un dipôle comprenant une diode OFT et un dispositif de commande de la diode OFT palliant tout ou partie des inconvénients des dispositifs connus de commande d'une diode OFT.

Un mode de réalisation prévoit un dispositif comprenant :
une source de courant commandable connectée entre un premier noeud et une première borne destinée à être reliée à une cathode d'une diode commandable ;
une capacité connectée entre le premier noeud et une deuxième borne destinée à être reliée à une anode de la diode commandable ;
un premier interrupteur connecté entre le premier noeud et une troisième borne destinée à être reliée à une grille de la diode commandable ;
un deuxième interrupteur connecté entre les deuxième et troisième bornes ; et
une première diode connectée entre la troisième borne et la deuxième borne, une anode de la première diode étant de préférence reliée à la troisième borne.

Selon un mode de réalisation, le dispositif comprend un circuit configuré pour commander la source de courant, le premier interrupteur et le deuxième interrupteur à partir d'une différence de potentiel entre les première et deuxième bornes.

Selon un mode de réalisation, le circuit est configuré pour :
commander une fourniture d'un courant à la capacité par ladite source lorsque ladite différence de potentiel est inférieure à un premier seuil de préférence négatif ou nul ;
commander une fermeture du premier interrupteur lorsque ladite différence de potentiel est supérieure à un deuxième seuil de préférence positif ou nul ; et
commander une fermeture du deuxième interrupteur lorsque ladite différence de potentiel est inférieure à un troisième seuil de préférence négatif ou nul.

Selon un mode de réalisation :
la source de courant est un premier transistor bipolaire, de type NPN, ayant un émetteur relié au premier noeud et un collecteur relié à la première borne ;
le premier interrupteur est un deuxième transistor bipolaire, de type PNP, ayant un émetteur relié au premier noeud et un collecteur relié à la troisième borne ; et
le deuxième interrupteur est un troisième transistor bipolaire, de type NPN, ayant un émetteur relié à la deuxième borne et un collecteur relié à la troisième borne.

Selon un mode de réalisation, le circuit comprend :
une première résistance reliant la première borne à une base du premier transistor ;
une deuxième résistance reliant la première borne à une base du deuxième transistor ;
une deuxième diode connectée entre la base du premier transistor et la base du deuxième transistor, une anode de la deuxième diode étant reliée à la base du premier transistor ; et
une troisième diode connectée entre la base du deuxième transistor et une base du troisième transistor, une anode de la troisième diode étant reliée à la base du deuxième transistor.

Selon un mode de réalisation, une tension de seuil de la deuxième diode est égale à une tension de seuil d'une diode base-émetteur du premier transistor.

Selon un mode de réalisation, une tension maximale aux bornes de la capacité est au moins en partie déterminée par une tension de seuil de la troisième diode.

Selon un mode de réalisation :
le premier seuil est au moins en partie déterminé par une tension de seuil de la première diode ; ou
ledit circuit comprend une diode, de préférence une diode Zener, connectée en série avec la première résistance entre la première borne et la base du premier transistor, le premier seuil étant au moins partiellement déterminé par une tension de seuil de mise en conduction en inverse de ladite diode.

Selon un mode de réalisation, le deuxième seuil est au moins en partie déterminé par une tension de seuil de la troisième diode et/ou par une tension de seuil de la diode commandable.

Selon un mode de réalisation :
le troisième seuil est au moins en partie déterminé par la tension de seuil de la troisième diode ; ou
le circuit comprend en outre une diode en série avec une troisième résistance entre la première borne et la base du troisième transistor, le troisième seuil étant au moins en partie déterminé par une tension de seuil de ladite diode.

Selon un mode de réalisation :
le circuit comprend en outre une résistance connectée entre la base du troisième transistor et la deuxième borne ; et/ou
le circuit comprend une diode de désaturation du troisième transistor, connectée entre la base et le collecteur du troisième transistor.

Selon un mode de réalisation, le dispositif comprend une inductance dont une borne est connectée à la deuxième borne et dont une autre borne est destinée à être reliée à l'anode de la diode commandable.

Selon un mode de réalisation, la diode commandable est une diode OFT comprenant plusieurs structures comprenant chacune, dans une tranchée d'un substrat, une première région conductrice séparée du substrat d'une première distance inférieure à environ 10 nm, et une deuxième région conductrice s'étendant dans la tranchée plus profondément que la première région, la diode étant définie par un ou plusieurs transistors dont au moins une région de canal s'étend entre deux des tranchées, les premières régions conductrices définissant les grilles des transistors et une grille de la diode.

Un autre mode de réalisation prévoit un dipôle comprenant :
un dispositif tel que décrit ci-dessus, la première borne du dispositif définissant une cathode du dipôle et la deuxième borne dudit dispositif définissant une anode du dipôle ; et
une diode commandable, de préférence une diode OFT, ayant une cathode connectée à la première borne du dispositif, une anode reliée à la deuxième borne du dispositif et une grille connectée à la troisième borne du dispositif.

Un autre mode de réalisation prévoit une alimentation à découpage comprenant un dispositif tel que décrit ci-dessus ou un dipôle tel que décrit ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, est une reproduction de la figure 1 de la demande de brevet US2020105946, illustrant un exemple d'une diode OFT ;
la figure 2 représente, de manière schématique et sous la forme d'un circuit, un mode de réalisation d'un convertisseur de puissance comprenant une diode OFT et son dispositif de commande selon un mode de réalisation ;
la figure 3 représente, de manière schématique et sous la forme d'un circuit, un mode de réalisation du dispositif de commande de la figure 2 ;
la figure 4 représente, de manière schématique et sous la forme d'un circuit, un mode de réalisation plus détaillé du dispositif de commande de la figure 3 ;
la figure 5 représente, de manière schématique et sous la forme d'un circuit, une variante de réalisation du dispositif de commande de la figure 4 ;
la figure 6 représente, de manière schématique et sous la forme d'un circuit, une autre variante de réalisation du dispositif de commande de la figure 4 ; et
la figure 7 représente, de manière schématique et sous la forme d'un circuit, encore une autre variante de réalisation du dispositif de commande de la figure 4.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits électroniques usuels, par exemple des convertisseurs de puissance à découpage ou des ponts redresseurs, comprenant un dipôle mettant en œuvre une fonction de diode, par exemple de redressement, n'ont pas été détaillés, les modes décrits étant compatibles avec ces circuits usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

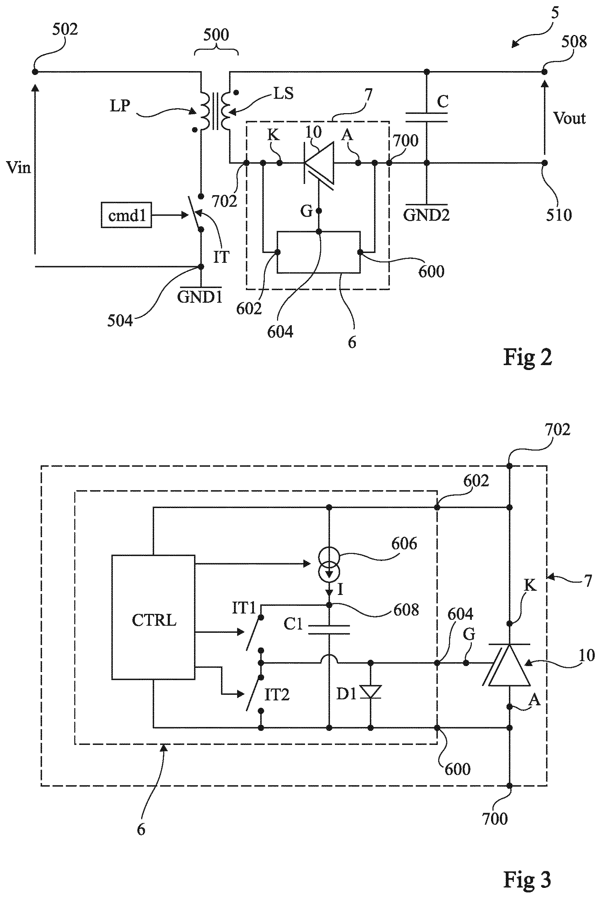

La figure 2 représente, de manière schématique et sous la forme d'un circuit, un mode de réalisation d'une alimentation à découpage ("Switched Mode Power Supply"), ou SMPS, comprenant une diode OFT, par exemple la diode 10 de la figure 1, et son dispositif de commande 6 selon un mode de réalisation. Dans cet exemple, la diode 10 et son dispositif, ou circuit, de commande 6 sont représentés sous la forme d'un dipôle 7 (délimité par des traits en pointillé en figure 2), le dipôle 7 comprenant une borne d'anode 700 et une borne de cathode 702.

L'alimentation à découpage 5 est, dans cet exemple, une alimentation à isolation galvanique comprenant un transformateur d'isolement 500. Plus particulièrement, l'alimentation à découpage 5 est communément appelée alimentation "fly-back" en langue anglaise.

Le transformateur 500 comprend un enroulement primaire LP et un enroulement secondaire LS.

L'enroulement primaire LP est connecté en série avec un interrupteur IT, entre une borne 502 d'application d'un potentiel d'entrée Vin et une borne 504 d'application d'un potentiel de référence GND1 auquel est référencé le potentiel Vin. A titre d'exemple, l'interrupteur IT est connecté entre l'enroulement LP et la borne 504. Dans cet exemple, le point de phase de l'enroulement LP est du côté de la borne 504.

L'alimentation à découpage 5 comprend un circuit de commande cmd1 de l'interrupteur IT. Le circuit cmd1 est configuré pour commander des ouvertures et des fermetures de l'interrupteur IT, sur la base d'un écart entre une valeur de consigne et une valeur courante (ou mesurée) d'un potentiel de sortie Vout de l'alimentation 5, de sorte que le potentiel Vout soit régulé à cette valeur de consigne.

Le dipôle 7 est connecté en série avec l'enroulement LS, entre une borne 508 de fourniture du potentiel Vout et une borne 510 d'application d'un potentiel de référence GND2 auquel est référencé le potentiel Vout. Une capacité C de filtrage est connectée entre les bornes 508 et 510, en parallèle de l'association série du dipôle 7 et de l'enroulement LS.

Dans cet exemple, le point de phase de l'enroulement LS est du côté de la borne 508. Dans cet exemple, l'anode 700 du dipôle 7 est reliée, de préférence connectée, à la borne 510, et la cathode 702 du dipôle 7 est reliée, de préférence connectée, à l'enroulement LS.

Le dispositif 6 de commande comprend une borne 600 destinée à être reliée, de préférence connectée, à l'anode A de la diode 10, une borne 602 destinée à être reliée, par exemple connectée, à une cathode K de la diode 10, et une borne 604 destinée à être reliée, de préférence connectée, à une borne de grille G de la diode 10. Lorsque la diode 10 et le dispositif 6 sont effectivement reliés et forment le dipôle 7 représenté en figure 2, la borne 600 constitue la borne d'anode 700 du dipôle 7 et la borne 602 constitue la borne de cathode 702 du dipôle 7. En d'autres mots, les bornes 600 et 700 sont confondues, les bornes 602 et 702 étant également confondues. Dit encore autrement, la borne 600 est connectée à la borne 700 du dipôle 7, la borne 602 étant connectée à la borne 702 du dipôle 7.

Le dispositif 6 est configuré pour commander la diode 10, c'est-à-dire pour fournir un potentiel de commande sur la grille G de la diode 10, uniquement à partir de la différence de potentiel entre ses bornes 600 et 602, c'est-à-dire la différence de potentiel entre les bornes 700 et 702 du dipôle 7. Dans la suite de la description, la différence de potentiel entre les bornes 600 et 602, respectivement 700 et 702, correspond au potentiel de la borne 600, respectivement 700, auquel est soustrait le potentiel la borne 602, respectivement 702. Dit autrement, la différence de potentiel entre les bornes 600 et 602, respectivement 700 et 702, est référencée à la borne 600, respectivement 700.

A titre d'exemple, selon un mode de réalisation, la diode OFT 10 est conductrice lorsqu'une tension Vak entre son anode A et sa cathode K, référencée à la cathode K, est positive (état polarisé en direct) et une tension Vga entre sa grille G et son anode A, référencée à l'anode A, est positive ou nulle. En outre, la diode OFT 10 est bloquée lorsque la tension Vak est négative (état polarisé en inverse) et la tension Vga est nulle ou négative. Dans une telle diode OFT 10, dans l'état polarisé en direct, plus la tension Vga est élevée, plus la tension Vak est faible. Cependant, au moment où la diode OFT 10 commute de l'état polarisé en direct à l'état polarisé en inverse, plus la tension Vga est élevée, plus la décharge de sa grille G est lente au moment de cette commutation, et plus les courants de fuite dans la diode OFT 10 sont élevés au moment de cette commutation.

La figure 3 représente, de manière schématique et sous la forme d'un circuit, un mode de réalisation du dispositif de commande 6 de la figure 2. Plus exactement, la figure 3 représente le dipôle 7 de la figure 2, ou, dit autrement, la figure 3 représente le dispositif 6 connecté à la diode OFT qu'il commande, à savoir la diode 10 dans cet exemple. En figure 3, le dipôle 7 et le dispositif 6 sont délimités chacun par des traits en pointillé.

Le dispositif 6 comprend une source de courant 606. Le source de courant 606 est connectée entre un noeud 608 du dispositif 6 et la borne 602 du dispositif 6. Dit autrement, une borne de la source de courant est reliée, de préférence connectée, au noeud 608, l'autre borne de la source de courant 606 étant reliée, de préférence connectée, à la borne 602.

La source de courant 606 est commandable, c'est-à-dire que, en fonction d'une commande, ou signal de commande, qu'elle reçoit, elle fournit ou non un courant I positif circulant de la borne 602 vers le noeud 608.

Le dispositif 6 comprend une capacité C1. La capacité C1 est connectée entre le noeud 608 et la borne 600 du dispositif 6. Dit autrement, une borne de la capacité C1 est reliée, de préférence connectée, au noeud 608, l'autre borne de la capacité C1 étant reliée, de préférence connectée, à la borne 600.

Le dispositif 6 comprend une diode D1 connectée entre les bornes 604 et 600, l'anode de la diode D1 étant du côté de la borne 604. Dit autrement, l'anode de la diode D1 est reliée à la borne 604, la cathode de la diode D1 étant reliée, de préférence connectée, à la borne 600. La diode D1 correspond, par exemple, à une diode unique, ou à plusieurs diodes en série, ce qui permet d'ajuster le seuil de mise en conduction, ou tension de seuil, de la diode D1.

Le dispositif 6 comprend un interrupteur IT1. L'interrupteur IT1 est connecté entre le noeud 608 et la borne 604 du dispositif 6. Dit autrement, une borne de l'interrupteur IT1 est reliée, de préférence connectée, au noeud 608, l'autre borne de l'interrupteur IT1 étant reliée, de préférence connectée, à la borne 604.

Lorsque l'interrupteur IT1 est bloqué, la capacité C1 peut être chargée par le courant I délivré par la source de courant 606.

Lorsque l'interrupteur IT1 est passant, ce dernier est configuré pour décharger la capacité C1 à travers la diode D1, de sorte qu'un potentiel non nul et positif, par exemple référencé par rapport au potentiel de la borne 600, soit présent sur la borne 604, et donc appliqué à la grille G de la diode 10. La tension de seuil de la diode D1 détermine donc, au moins partiellement, la valeur de la différence de potentiel positive et non nulle appliquée entre les bornes G et A de la diode 10, lorsque l'interrupteur IT1 est fermé et que la capacité C1 se décharge à travers la diode D1.

Selon un mode de réalisation, la tension de seuil de la diode D1 est déterminée par un compromis entre la tension Vak de la diode 10 polarisée en direct et les courants de fuite dans la diode 10 au moment de la commutation de la diode 10 de l'état polarisé en direct à l'état polarisé en inverse.

Le dispositif 6 comprend un interrupteur IT2. L'interrupteur IT2 est connecté entre les bornes 600 et 604. Dit autrement, les interrupteurs IT1 et IT2 sont connectés en série entre le noeud 608 et la borne 600, l'interrupteur IT1 étant du côté du noeud 608, et le noeud de connexion entre les interrupteurs IT1 et IT2 correspondant à la borne 604 du dispositif 6. Dit encore autrement, une borne de l'interrupteur IT2 est reliée, de préférence connectée, à la borne 604, l'autre borne de l'interrupteur IT2 étant reliée, de préférence connectée, à la borne 600.

Lorsqu'il est passant, l'interrupteur IT2 est configuré pour relier électriquement les bornes 604 et 600, c'est-à-dire pour court-circuiter la borne 604 à la borne 600.

Les interrupteurs IT1 et IT2 sont configurés pour ne pas être passants simultanément, les interrupteurs IT1 et IT2 pouvant toutefois être simultanément bloqués.

Selon un mode de réalisation, le dispositif 6 comprend un circuit CTRL. Le circuit CTRL est configuré pour commander la source de courant 606 et les interrupteurs IT1 et IT2, sur la base, ou à partir, de la différence de potentiel entre ses bornes 602 et 600.

Plus particulièrement, selon un mode de réalisation, le circuit CTRL est configuré pour commander la source de courant 606 de sorte qu'elle fournisse le courant I uniquement lorsque la différence de potentiel entre les bornes 600 et 602 est inférieure à un seuil Th1. A titre d'exemple le seuil est négatif ou nul. Dit autrement, le circuit CTRL est configuré pour commander la source 606 de manière à charger la capacité C1 lorsque la diode 10 est polarisée en inverse.

Selon un mode de réalisation, le circuit CTRL est en outre configuré pour commander une fermeture de l'interrupteur IT2 lorsque la différence de potentiel entre les bornes 600 et 602 est inférieure à un seuil Th2. A titre d'exemple, le seuil Th2 est négatif ou nul. A titre d'exemple, le seuil Th2 est inférieur au seuil Th1. La fermeture de l'interrupteur IT2 lorsque la diode 10 est polarisée en inverse permet de court-circuiter les bornes G et A de la diode 10, d'où il résulte une diminution du courant de fuite dans la diode 10 par rapport au cas où une différence de potentiel positive et non nulle serait appliquée entre les bornes G et A de la diode 10 polarisée en inverse.

Selon un mode de réalisation, le circuit CTRL est configuré pour commander une fermeture de l'interrupteur IT1 lorsque la différence de potentiel entre les bornes 600 et 602 est supérieure à un seuil Th3. Le seuil Th3 est positif. La fermeture de l'interrupteur IT1 lorsque la diode 10 est polarisée en direct permet de fournir une différence de potentiel non nulle et positive entre les bornes 604 et 600, donc entre les bornes G et A, d'où il résulte une diminution de la différence de potentiel aux bornes de la diode 10 par rapport au cas où une différence de potentiel nulle serait appliquée entre les bornes G et A de la diode 10 polarisée en direct.

Selon un mode de réalisation, le circuit CTRL est alimenté par la différence de potentiel entre ses bornes 600 et 602. Dit autrement, aucune alimentation spécifique n'est prévue pour que le circuit CTRL puisse commander la source 606 et les interrupteurs IT1 et IT2 décrits ci-dessus.

On aurait pu penser remplacer la diode 10 par un transistor MOS (de l'anglais "Metal Oxide Semiconductor" - métal oxyde semiconducteur) usuel dont la source aurait été reliée à la borne 700 et le drain aurait été connecté à la borne 702. Toutefois, pour rendre passant le transistor MOS lorsque la différence de potentiel entre les bornes 700 et 702 aurait été positive, il aurait fallu appliquer un potentiel sur la grille du transistor MOS qui soit suffisamment supérieur à celui de sa source. Cela aurait nécessité la prévision de circuits logiques et d'une alimentation spécifique, par exemple une pompe de charges ou par exemple un circuit extérieur au dispositif 6 ayant par exemple un enroulement secondaire supplémentaire, ce qui n'est pas le cas avec le dispositif de commande 6.

On aurait également pu penser à remplacer la diode 10 et son dispositif de commande 6 par une diode usuelle non commandable (sans grille), mais le courant de fuite dans cette diode usuelle polarisée en inverse et la chute de tension aux bornes de cette diode usuelle polarisée en direct auraient alors été plus élevés qu'avec la diode 10 et son dispositif de commande 6.

Selon un mode de réalisation, le circuit CTRL ne comprend que des composants résistifs, des diodes et une éventuelle inductance (non représentés en figure 3). Le circuit CTRL est alors plus simple qu'un circuit de commande qui comprendrait des comparateurs, par exemple mis en œuvre au moyen d'amplificateurs opérationnels nécessitant une alimentation dédiée, ces amplificateurs étant par exemple configurés pour détecter des inversions de signe, ou polarité, de la différence de potentiel entre les bornes K et A de la diode 10.

Plus particulièrement, selon un mode de réalisation, la source de courant 606 et les interrupteurs IT1 et IT2 sont chacun mis en œuvre par un transistor bipolaire. Dans ce cas, le circuit CTRL met en œuvre la commande décrite précédemment de la source de courant 606 et des interrupteurs IT1 et IT2, uniquement en polarisant de manière correspondante les transistors bipolaires à partir de la différence de potentiel entre les bornes 600 et 602.

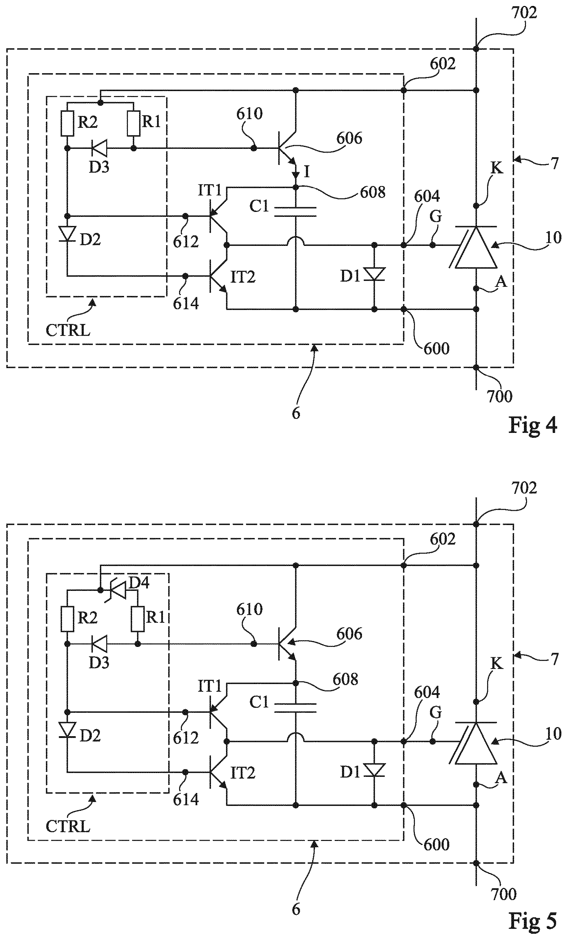

La figure 4 représente, de manière schématique et sous la forme d'un circuit, un mode de réalisation plus détaillé du dispositif de commande 6. Seules les différences entre le dispositif 6 de la figure 3 et celui de la figure 4 sont ici détaillées. Par ailleurs, comme en figure 3, en figure 4 le dispositif 6 est représenté connecté à la diode qu'il commande, à savoir dans cet exemple la diode 10, l'ensemble définissant le dipôle 7. En figure 4, les éléments 6, 7 et CTRL sont délimités chacun par des traits en pointillé.

Dans ce mode de réalisation, la source de courant 606 est mise en œuvre par un transistor bipolaire de type NPN. Le collecteur du transistor 606 est relié, de préférence connecté, à la borne 602. L'émetteur du transistor 606 est relié, de préférence connecté, au noeud 608. La base 610 du transistor 606 est reliée, de préférence connectée, au circuit CTRL.

Dans ce mode de réalisation, l'interrupteur IT1 est mis en œuvre par un transistor bipolaire de type PNP. L'émetteur du transistor IT1 est relié, de préférence connecté, au noeud 608. Le collecteur du transistor IT1 est relié, de préférence connecté, à la borne 604. La base 612 du transistor IT1 est reliée, de préférence connectée, au circuit CTRL.

Dans ce mode de réalisation, l'interrupteur IT2 est mis en œuvre par un transistor bipolaire de type NPN. L'émetteur du transistor IT2 est relié, de préférence connecté, à la borne 600. Le collecteur du transistor IT2 est relié, de préférence connecté, à la borne 604, donc au collecteur du transistor IT1. La base 614 du transistor IT2 est reliée, de préférence connectée, au circuit CTRL.

Selon un mode de réalisation, comme cela est illustré en figure 4, le circuit CTRL comprend une résistance, ou composant résistif, R1, la résistance R1 reliant la borne 602 à la base 610 du transistor 606. Dit autrement, une borne de la résistance R1 est reliée, de préférence connectée, à la borne 602, une autre borne de la résistance étant reliée, de préférence connectée, à la base 610 du transistor 606.

La résistance R1 permet, lorsque la différence de potentiel entre les bornes 600 et 602 est négative (diode 10 polarisée en inverse) et inférieure au seuil Th1, de rendre passant le transistor 606, et, plus particulièrement, de lui fournir un courant de base positif. Le transistor 606 fournit alors le courant I au noeud 608.

Selon un mode de réalisation, comme cela est représenté en figure 4, le circuit CTRL comprend également une résistance, ou élément résistif, R2, la résistance R2 reliant la borne 602 à la base 612 du transistor IT1. Dit autrement, une borne de la résistance R2 est reliée, de préférence connectée, à la borne 602, une autre borne de la résistance étant reliée, de préférence connectée, à la base 612 du transistor IT1. Le circuit CTRL comprend, en outre, une diode D2 connectée entre la base 612 du transistor IT1 et la base 614 du transistor IT2, l'anode de la diode D2 étant du côté de la base 612 du transistor IT1. Dit autrement, l'anode de la diode D2 est reliée, de préférence connectée, à la base 612 du transistor IT1, la cathode de la diode D2 étant reliée, de préférence connectée, à la base 614 du transistor IT2. Ainsi, la résistance R2 et la diode D2 sont connectées en série entre la borne 602 et la base 614 du transistor IT2, la base 612 du transistor IT1 étant reliée ou connectée au noeud de connexion de la diode D2 à la résistance R2. En outre, le circuit CTRL comprend une diode D3 connectée entre la base 610 du transistor 606 et la base 612 du transistor IT1, l'anode de la diode D3 étant du côté de la base 610 du transistor 606. Dit autrement, l'anode de la diode D3 est reliée, de préférence connectée, à la borne de la résistance R1 opposée à la borne 602, la cathode de la diode D3 étant reliée, de préférence connectée, à la borne de la résistance R2 opposée à la borne 602.

De préférence, le seuil de mise en conduction de la diode D3, qui peut correspondre à une unique diode ou à plusieurs diodes en série, est sensiblement égal, par exemple égal, à la différence de potentiel entre la base 610 et l'émetteur du transistor 606 lorsque celui-ci délivre le courant I, c'est-à-dire au seuil de mise en conduction, ou tension de seuil, de la diode base-émetteur du transistor 606. Ainsi, lorsque le transistor 606 délivre le courant I, la différence de potentiel entre le noeud 608 et la base 612 du transistor IT1 est nulle, d'où il résulte que le transistor IT1 est bloqué et que la capacité C1 se charge.

La tension de seuil de la diode D2, qui peut correspondre à une unique diode ou à plusieurs diodes en série, détermine, au moins en partie, une valeur maximale de la différence de potentiel aux bornes de la capacité C1, donc une valeur maximale du potentiel du noeud 608. En effet, lorsque l'interrupteur IT2 est fermé (passant), l'interrupteur IT1 ouvert (ouvert), et que la source 606 délivre le courant I, le potentiel du noeud 608 est au plus égal à la somme du potentiel de la borne 600, de la tension base-émetteur du transistor IT2, de la différence de potentiel aux bornes de la diode D2, de la différence de potentiel aux bornes de la diode D3 et de la tension base-émetteur du transistor 606.

A titre d'exemple, lorsque :
la diode D2 correspond à deux diodes en série ayant chacune un seuil de mise en conduction égal à une valeur Vj, par exemple égale à 0,7 V ;
la tension base-émetteur du transistor IT2 est égale à Vj lorsque le transistor IT2 est passant ; et
la différence de potentiel aux bornes de la diode D3 et la tension base-émetteur du transistor 606 s'annulent, alors la tension maximale aux bornes de la capacité C1 est égale à 3*Vj. Dit autrement, la tension aux bornes de la capacité C1 est régulée à la valeur 3*Vj.

Dans ce mode de réalisation, dès que la différence de potentiel entre les bornes 600 et 602 est suffisamment négative (diode 10 polarisée en inverse) pour qu'un courant circule dans la résistance R2 et la diode D2, de la borne 602 vers la base 614 du transistor IT2, le transistor IT2 devient passant et court-circuite les bornes 604 et 600. Ainsi, dans ce mode de réalisation, la tension de seuil de la diode D2 détermine au moins en partie le seuil Th2, qui est alors strictement négatif.

Par ailleurs, dans ce mode de réalisation, le transistor 606 devient passant lorsque le potentiel de la borne 602 est suffisamment supérieur au potentiel du noeud 608. Ainsi, dans ce mode de réalisation, le seuil Th1 est au moins en partie déterminé par la tension de seuil de la diode D1, du fait que la tension de seuil de la diode D1 détermine au moins en partie le potentiel du noeud 608 lorsque l'interrupteur IT1 est passant et que la diode 10 est polarisée en direct.

Dans le dispositif 6 de la figure 4, lorsque la différence de potentiel entre les bornes 600 et 602 est positive (diode 10 polarisée en direct), les transistors IT2 et 606 sont bloqués. En outre, lorsqu'un courant positif circulant de la borne 600 vers la borne 602 est fourni à la borne 600, et que le potentiel du noeud 608 est suffisamment supérieur au potentiel de la borne 602, le transistor IT1 devient passant. Lorsque la différence de potentiel entre les bornes 600 et 602 est positive et les transistors IT2 et 606 sont bloqués, la différence de potentiel entre les noeuds 608 et 602 est définie par la somme de la différence de potentiel aux bornes de la capacité C1 et de la chute de tension aux bornes de la diode 10. Par conséquent, la tension de seuil de la diode 10 détermine au moins en partie le seuil Th3. Dit autrement, le seuil Th3 est déterminé, au moins partiellement, par la tension de seuil de la diode D2, du fait que la tension de seuil de la diode D2 détermine au moins en partie la différence de potentiel aux bornes de la capacité C1 juste avant que l'interrupteur IT1 ne devienne passant.

La personne du métier est en mesure de modifier les seuils Th1, Th2 et Th3, et/ou la valeur maximale à laquelle est régulé le potentiel du noeud 608, par exemple en adaptant la valeur de la tension de seuil de la diode D2. En outre, la personne du métier est en mesure de modifier la valeur de la différence de potentiel appliquée entre les bornes G et A de la diode 10 lorsque le transistor IT1 est passant, par exemple en modifiant le seuil de mise en conduction de la diode D1 et éventuellement en adaptant la valeur de la capacité C1.

La figure 5 représente, de manière schématique et sous la forme d'un circuit, une variante de réalisation du dispositif de commande 6 de la figure 4. Seules les différences entre le dispositif 6 de la figure 4 et celui de la figure 5 sont ici détaillées. En figure 5, comme en figures 3 et 4, le dispositif 6 est représenté connecté à la diode qu'il commande, à savoir dans cet exemple la diode 10, l'ensemble du dispositif 6 et de la diode 10 définissant le dipôle 7. En figure 5, les éléments 6, 7 et CTRL sont délimités chacun par des traits en pointillé.

Le dispositif 6 de la figure 5 diffère de celui de la figure 4 en ce qu'il comprend une diode D4, de préférence une diode Zener, connectée en série avec la résistance R1, entre la borne 602 et la base 610 du transistor 606, l'anode de la diode D4 étant du côté de la base 610 du transistor 606. La diode D4 peut correspondre à une unique diode ou à plusieurs diodes en série.

Dans cette variante de réalisation, pour que le transistor 606 soit passant et délivre le courant I de charge de la capacité C1, le potentiel de la borne 602 doit être suffisamment supérieur au potentiel du noeud 608 pour permettre la mise en conduction en inverse de la diode Zener D4 et la fourniture d'un courant de base au transistor 606. La diode Zener D4 permet donc d'abaisser la valeur du seuil Th1 conditionnant la fourniture du courant I de charge de la capacité C1.

Lorsque le dipôle 7 fait partie d'une alimentation à découpage, par exemple celle de la figure 2, le seuil Th1 est par exemple choisi, par exemple en adaptant la valeur du seuil de mise en conduction inverse de la diode D4, pour être inférieur à la différence de potentiel négative et maximale (en valeur absolue) qui peut être présente entre les bornes 600 et 602 lorsque l'alimentation à découpage fonctionne en mode de conduction discontinue ("Discontinuous Conduction Mode" en langue anglaise), ou DCM. Il en résulte que, en mode de conduction discontinue, la capacité C1 n'est pas chargée et que la source de courant 606 ne délivre donc pas de courant I de charge à la capacité C1.

Cela permet d'éviter que, entre une phase où la diode 10 est polarisée en direct et une phase où la diode 10 est polarisée en inverse et a ses bornes G et A court-circuitées par le transistor IT2, une différence de potentiel non nulle soit appliquée entre les bornes G et A de la diode 10 alors que la phase de conduction en direct de la diode 10 n'est pas immédiatement suivie d'une différence de potentiel entre les bornes K et A de la diode 10 suffisamment faible, par exemple négative, pour bloquer la diode 10, ce qui est généralement le cas dans une alimentation à découpage fonctionnant en mode DCM. Dit autrement, cela permet d'éviter d'appliquer une différence de potentiel positive et non nulle entre les bornes G et A de la diode 10, alors que la diode 10 fonctionne dans le quadrant Q1, ce qui conduirait à une augmentation des pertes qui pourraient être assimilées à des pertes par commutations dans l'alimentation à découpage.

Selon une autre variante de réalisation, non illustrée, pour limiter les pertes par commutation dans une alimentation à découpage fonctionnant en mode de conduction discontinue, plutôt que la diode D4 permettant d'abaisser le seuil Th1, le dispositif 6 comprend un circuit configuré pour court-circuiter les bornes 604 et 600 dès que la différence de potentiel entre les bornes K et A de la diode 10 est faiblement positive, c'est-à-dire, par exemple, lorsque cette différence de potentiel est supérieure au seuil de mise en conduction de la diode 10 mais que l'écart entre cette différence de potentiel et le seuil de mise en conduction de la diode 10 est inférieur à 0,1 V, par exemple inférieur à 0,05 V, voire inférieur à 0,01 V. Cette différence de potentiel faiblement positive correspond par exemple à un courant en direct dans la diode 10 inférieur ou égal à 100 mA. La mise en œuvre de cette variante de réalisation à l'aide de circuits logiques est à la portée de la personne du métier.

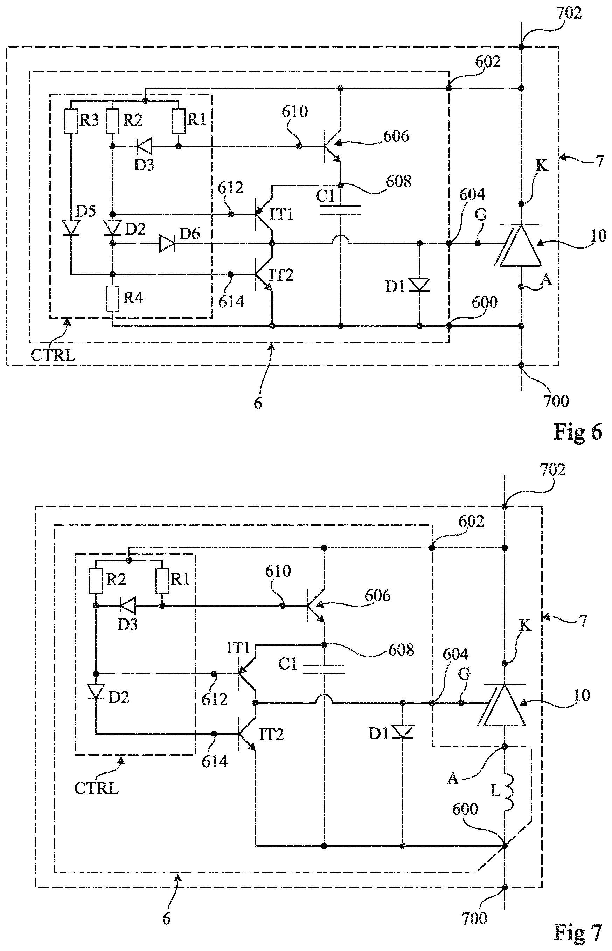

La figure 6 représente, de manière schématique et sous la forme d'un circuit, une autre variante de réalisation du dispositif de commande 6 de la figure 4. Seules les différences entre le dispositif 6 de la figure 4 et celui de la figure 6 sont ici détaillées. En figure 6, comme en figures 3, 4 et 5, le dispositif 6 est représenté connecté à la diode qu'il commande, à savoir dans cet exemple la diode 10, l'ensemble du dispositif 6 et de la diode 10 définissant le dipôle 7. En figure 6, les éléments 6, 7 et CTRL sont délimités chacun par des traits en pointillé.

Dans cette variante, le seuil Th2 n'est pas au moins en partie déterminé par la tension de seuil de la diode D2. Plus particulièrement, dans cette variante de réalisation, la tension maximale aux bornes de la capacité C1 et le seuil Th2 sont décorrélés l'un de l'autre. En effet, dans cette variante, on prévoit ici que le seuil Th2 soit plus faible que dans les modes de réalisation et variantes décrits précédemment, sans que cela ne modifie la tension maximale pouvant être présente aux bornes de la capacité C1.

Pour cela, le dispositif 6, et, plus particulièrement, son circuit CTRL, comprennent une diode D5 en série avec une résistance R3, entre la borne 602 et la base 614 du transistor IT2. La diode D5 correspond à une diode unique ou à plusieurs diodes en série. La cathode de la diode D5 est du côté de la base 614 du transistor IT2. Dit autrement, la cathode de la diode D5 est reliée, par exemple connectée, à la base 614 du transistor IT2.

Dans cette variante de réalisation, dès que la différence de potentiel négative entre les bornes 600 et 602 (diode 10 polarisée en inverse) est supérieure à la tension de seuil de la diode D5, le transistor IT2 devient passant et court-circuite les bornes 604 et 600. En choisissant une diode D5 ayant un seuil de mise en conduction inférieur à celui de la diode D2, cela permet de réduire (en valeur absolue) la valeur du seuil Th2, et donc de court-circuiter plus rapidement les bornes G et A de la diode 10 polarisée en inverse de manière à réduire son courant de fuite.

Ainsi, dans cette variante, la tension de la diode D5 détermine au moins en partie le seuil Th2.

Selon un mode de réalisation, le circuit CTRL comprend en outre une résistance R4 optionnelle connectée entre la base 614 du transistor IT2 et la borne 600. Cette résistance permet d'ajuster la polarisation du transistor IT2 à l'état passant. Bien que la prévision de la résistance R4 soit décrite en relation avec la variante de réalisation de la figure 6, la résistance R4 peut également être prévue dans les modes de réalisation et variantes décrits en relation avec les figures 4 et 5, ainsi que dans la variante de réalisation qui sera décrite ci-après en relation avec la figure 7.

Selon un mode de réalisation, le circuit CTRL comprend en outre une diode D6 de désaturation du transistor IT2. La diode D6 est connectée entre la base 614 et le collecteur 604 du transistor IT2, l'anode de la diode D6 étant du côté de la base 614 du transistor IT2. La diode D6 permet de diminuer la saturation du transistor IT2 afin d'accélérer le passage à l'état bloqué de celui-ci. Une solution analogue pourrait être envisagée pour le transistor IT1. Bien que la prévision de la diode D6 soit décrite en relation avec la variante de réalisation de la figure 6, la diode D6 peut également être prévue dans les modes de réalisation et variantes décrits en relation avec les figures 4 et 5, ainsi que dans la variante de réalisation qui va maintenant être décrite en relation avec la figure 7.

La figure 7 représente, de manière schématique et sous la forme d'un circuit, une variante de réalisation du dispositif de commande 6 de la figure 4. Seules les différences entre le dispositif 6 de la figure 4 et celui de la figure 7 sont ici détaillées. En figure 7, comme en figures 3, 4, 5 et 6, le dispositif 6 est représenté connecté à la diode qu'il commande, à savoir la diode 10 dans cet exemple, l'ensemble du dispositif 6 et de la diode 10 définissant le dipôle 7. En figure 7, les éléments 6, 7 et CTRL sont délimités chacun par des traits en pointillé.

Dans cette variante, applicable aux modes de réalisation et variantes décrits précédemment, le dispositif 6 comprend une inductance L reliant la borne 600 du dispositif 6 à l'anode A de la diode 10. Dit autrement, l'inductance L est connectée entre la borne 600 et l'anode A de la diode 10. Dit encore autrement, l'inductance L a une borne reliée, de préférence connectée, à la borne 600, et une autre borne destinée à être reliée, par exemple connectée, à l'anode A de la diode 10. Ainsi, par rapport aux modes de réalisation et variantes décrits précédemment où la borne 600 était par exemple connectée à l'anode A de la diode 10, dans cette variante, la borne 600 est reliée à l'anode A de la diode 10 par l'inductance L.

L'inductance L est parcourue par le même courant que la diode 10. L'inductance L permet de limiter l'amplitude de la différence de potentiel entre les bornes G et A de la diode 10 lorsque le transistor IT1 devient passant, ou, dit autrement, permet d'éviter une surtension entre les bornes G et A de la diode 10. En outre, l'inductance L permet que la différence de potentiel entre les bornes G et A de la diode 10 soit plus rapidement nulle lorsque la diode 10 passe d'une polarisation directe à une polarisation inverse.

A titre d'exemple, l'inductance L a une valeur comprise entre quelques nH et quelques dizaines de nH, par exemple entre 5 et 30 nH, la valeur de l'inductance L étant par exemple égale à 10 nH. Toutefois, la personne du métier est en mesure d'adapter la valeur de l'inductance L en fonction des variations du courant dans la diode 10, notamment de la pente de ces variations de courant. La valeur de l'inductance L peut être ajustée, par exemple, en ajustant la longueur des pistes conductrices ou de la connectique du circuit.

Dans les modes et variantes décrits précédemment, le dispositif 6 et la diode 10 qu'il commande définissent le dipôle 7. Le dispositif 6 et la diode 10 sont de préférence mis en œuvre dans et sur une même portion d'un substrat semiconducteur, par exemple le substrat 20 (figure 1). Toutefois, on peut prévoir que le dispositif 6 corresponde à un premier composant mis en œuvre dans et sur un premier substrat semiconducteur et que la diode OFT qu'il commande soit mise en œuvre dans et sur un autre substrat semiconducteur.

Bien que l'on ait décrit ci-dessus des modes de réalisation et variantes dans le cas où le dispositif 6 commande la diode OFT 10 décrite en relation avec la figure 1, la personne du métier est en mesure d'adapter le dispositif 6 à d'autres diodes commandables, par exemple à d'autres diodes OFT.

Par ailleurs, bien que l'on ait décrit, à titre d'exemple, le cas où le dipôle 7 fait partie de l'alimentation à découpage 5 (figure 2), la personne du métier est en mesure de prévoir le dipôle 7 dans d'autres circuits, par exemple dans d'autres circuits de puissance tels que des alimentations à découpage différentes de celle de la figure 2, ou encore des ponts redresseurs de tension.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus. En particulier, la personne du métier est en mesure, à partir de ces indications fonctionnelles, d'adapter les valeurs de la capacité C1, les valeurs des résistances du circuit CTRL et les tensions de seuil des diodes du circuit CTRL, en fonction de l'application visée et/ou des caractéristiques électriques de la diode OFT que le dispositif 6 est destiné à commander.

## Revendications

1. Dispositif (6) comprenant :
une source de courant commandable (606) connectée entre un premier noeud (608) et une première borne (602) destinée à être reliée à une cathode (K) d'une diode commandable (10) ;
une capacité (C1) connectée entre le premier noeud (608) et une deuxième borne (600) destinée à être reliée à une anode (A) de la diode commandable (10) ;
un premier interrupteur (IT1) connecté entre le premier noeud (608) et une troisième borne (604) destinée à être reliée à une grille (G) de la diode commandable (10) ;
un deuxième interrupteur (IT2) connecté entre les deuxième (600) et troisième (604) bornes ; et
une première diode (D1) connectée entre la troisième borne (604) et la deuxième borne (600), une anode de la première diode (D1) étant reliée à la troisième borne (604).

2. Dispositif selon la revendication 1, comprenant un circuit (CTRL) configuré pour commander la source de courant (606), le premier interrupteur (IT1) et le deuxième interrupteur (IT2) à partir d'une différence de potentiel entre les première (602) et deuxième (600) bornes.

3. Dispositif selon la revendication 2, dans lequel le circuit (CTRL) est configuré pour :
commander une fourniture d'un courant (I) à la capacité (C1) par ladite source (606) lorsque ladite différence de potentiel est inférieure à un premier seuil de préférence négatif ou nul ;
commander une fermeture du premier interrupteur (IT1) lorsque ladite différence de potentiel est supérieure à un deuxième seuil de préférence positif ou nul ; et
commander une fermeture du deuxième interrupteur (IT2) lorsque ladite différence de potentiel est inférieure à un troisième seuil de préférence négatif ou nul.

4. Dispositif selon la revendication 3, dans lequel :
la source de courant (606) est un premier transistor bipolaire, de type NPN, ayant un émetteur relié au premier noeud (608) et un collecteur relié à la première borne (602) ;
le premier interrupteur (IT1) est un deuxième transistor bipolaire, de type PNP, ayant un émetteur relié au premier noeud (608) et un collecteur relié à la troisième borne (604) ; et
le deuxième interrupteur (IT2) est un troisième transistor bipolaire, de type NPN, ayant un émetteur relié à la deuxième borne (600) et un collecteur relié à la troisième borne (604).

5. Dispositif selon la revendication 4, dans lequel ledit circuit (CTRL) comprend :
une première résistance (R1) reliant la première borne (602) à une base (610) du premier transistor (606) ;
une deuxième résistance (R2) reliant la première borne (612) à une base (612) du deuxième transistor (IT1) ;
une deuxième diode (D3) connectée entre la base (610) du premier transistor (606) et la base (612) du deuxième transistor (IT1), une anode de la deuxième diode (D3) étant reliée à la base (610) du premier transistor (606) ; et
une troisième diode (D2) connectée entre la base (612) du deuxième transistor (IT1) et une base (614) du troisième transistor (IT2), une anode de la troisième diode (D2) étant reliée à la base (612) du deuxième transistor (IT1).

6. Dispositif selon la revendication 5, dans lequel une tension de seuil de la deuxième diode (D3) est égale à une tension de seuil d'une diode base-émetteur du premier transistor (606).

7. Dispositif selon la revendication 5 ou 6, dans lequel une tension maximale aux bornes de la capacité (C1) est au moins en partie déterminée par une tension de seuil de la troisième diode (D2).

8. Dispositif selon l'une quelconque des revendications 5 à 7 :
dans lequel le premier seuil est au moins en partie déterminé par une tension de seuil de la première diode (D1) ; ou
dans lequel ledit circuit (CTRL) comprend une diode (D4), de préférence une diode Zener, connectée en série avec la première résistance (R1) entre la première borne (602) et la base (614) du premier transistor (606), le premier seuil étant au moins partiellement déterminé par une tension de seuil de mise en conduction en inverse de ladite diode (D4).

9. Dispositif selon l'une quelconque des revendications 5 à 8 dans lequel le deuxième seuil est au moins en partie déterminé par une tension de seuil de la troisième diode (D2) et/ou par une tension de seuil de la diode commandable (10).

10. Dispositif selon l'une quelconque des revendications 5 à 9 :
dans lequel le troisième seuil est au moins en partie déterminé par la tension de seuil de la troisième diode (D2) ; ou
dans lequel le circuit (CTRL) comprend en outre une diode (D5) en série avec une troisième résistance (R3) entre la première borne (602) et la base (614) du troisième transistor (IT2), le troisième seuil étant au moins en partie déterminé par une tension de seuil de ladite diode (D5).

11. Dispositif selon l'une quelconque des revendications 5 à 10 :
dans lequel le circuit (CTRL) comprend en outre une résistance (R4) connectée entre la base (614) du troisième transistor (IT2) et la deuxième borne (600) ; et/ou
dans lequel le circuit (CTRL) comprend une diode de désaturation (D6) du troisième transistor (IT2), connectée entre la base (614) et le collecteur du troisième transistor (IT2).

12. Dispositif selon l'une quelconque des revendications 1 à 11, comprenant une inductance (L) dont une borne est connectée à la deuxième borne (600) et dont une autre borne est destinée à être reliée à l'anode de la diode commandable (10).

13. Dispositif selon l'une quelconque des revendications 1 à 12, dans lequel la diode commandable (10) est une diode OFT comprenant plusieurs structures (30A, 30) comprenant chacune, dans une tranchée (22) d'un substrat (20), une première région conductrice (302) séparée du substrat (20) d'une première distance (d) inférieure à environ 10 nm, et une deuxième région conductrice (306) s'étendant dans la tranchée (22) plus profondément que la première région (302), la diode (10) étant définie par un ou plusieurs transistors (T1) dont au moins une région de canal (202) s'étend entre deux des tranchées (22), les premières régions conductrices (302) définissant les grilles des transistors (T1) et une grille (G) de la diode (10).

14. Dipôle (7) comprenant :
un dispositif (6) selon l'une quelconque des revendications 1 à 13, la première borne (602) du dispositif définissant une cathode (702) du dipôle et la deuxième borne (600) dudit dispositif (6) définissant une anode (700) du dipôle ; et
une diode commandable (10), de préférence une diode OFT, ayant une cathode (K) connectée à la première borne (602) du dispositif (6), une anode (A) reliée à la deuxième borne (600) du dispositif (6) et une grille (G) connectée à la troisième borne (604) du dispositif (6).

15. Alimentation à découpage comprenant un dispositif selon l'une quelconque des revendications 1 à 13 ou un dipôle (7) selon la revendication 14.

## Patentansprüche

1. Einrichtung (6), die Folgendes aufweist:
eine steuerbare Stromquelle (606), die zwischen einem ersten Knoten (608) und einem ersten Anschluss (602) verbunden ist, der zum Koppeln mit einer Kathode (K) einer steuerbaren Diode (10) vorgesehen ist;
einen Kondensator (C1), der zwischen dem ersten Knoten (608) und einem zweiten Anschluss (600) verbunden ist, der zum Koppeln mit einer Anode (A) der steuerbaren Diode (10) vorgesehen ist;
einen ersten Schalter (IT1), der zwischen dem ersten Knoten (608) und einem dritten Anschluss (604) verbunden ist, der zum Koppeln mit einem Gate (G) der steuerbaren Diode (10) vorgesehen ist;
einen zweiten Schalter (IT2), der zwischen dem zweiten (600) und dem dritten (604) Anschluss verbunden ist; und
eine erste Diode (D1), die zwischen dem dritten Anschluss (604) und dem zweiten Anschluss (600) verbunden ist, wobei eine Anode der ersten Diode (D1) mit dem dritten Anschluss (604) gekoppelt ist.

2. Die Einrichtung nach Anspruch 1, aufweisend eine Schaltung (CTRL), die eingerichtet ist, die Stromquelle (606), den ersten Schalter (IT1) und den zweiten Schalter (IT2) basierend auf eine Potentialdifferenz zwischen dem ersten (602) und dem zweiten (600) Anschluss vorliegt.

3. Die Einrichtung nach Anspruch 2, wobei die Schaltung (CTRL) eingerichtet ist zum:
Steuern einer Zuführung eines Stroms (I) zu dem Kondensator (C1) aus der Quelle (606), wenn die Potentialdifferenz kleiner als ein erster Schwellenwert ist, vorzugsweise negativ oder null;
Steuern eines Schließens des ersten Schalters (IT1), wenn die Potentialdifferenz größer als ein zweiter Schwellenwert ist, vorzugsweise positiv oder null; und
Steuern eines Schließens des zweiten Schalters (IT2), wenn die Potentialdifferenz kleiner als ein dritter Schwellenwert ist, vorzugsweise negativ oder null.

4. Die Einrichtung nach Anspruch 3, wobei:
die Stromquelle (606) ein erster NPN-Typ-Bipolartransistor ist, der einen Emitter, der mit dem ersten Knoten (608) gekoppelt ist, und einen Kollektor, der mit dem ersten Anschluss (602) gekoppelt ist, hat;
der erste Schalter (IT1) ein zweiter PNP-Typ-Bipolartransistor ist, der einen Emitter, der mit dem ersten Knoten (608) gekoppelt ist, und einen Kollektor, der mit dem dritten Anschluss (604) gekoppelt ist, hat; und
der zweite Schalter (IT2) ein dritter NPN-Typ-Bipolartransistor ist, der einen Emitter, der mit dem zweiten Anschluss (600) gekoppelt ist, und einen Kollektor, der mit dem dritten Anschluss (604) gekoppelt ist, hat.

5. Die Einrichtung nach Anspruch 4, wobei die Schaltung (CTRL) Folgendes aufweist:
einen ersten Widerstand (R1), der den ersten Anschluss (602) mit einer Basis (610) des ersten Transistors (606) koppelt;
einen zweiten Widerstand (R2), der den ersten Anschluss (612) mit einer Basis (612) des zweiten Transistors (IT1) koppelt;
eine zweite Diode (D3), die zwischen der Basis (610) des ersten Transistors (606) und der Basis (612) des zweiten Transistors (IT1) verbunden ist, wobei eine Anode der zweiten Diode (D3) mit der Basis (610) des ersten Transistors (606) gekoppelt ist; und
eine dritte Diode (D2), die zwischen der Basis (612) des zweiten Transistors (IT1) und einer Basis (614) des dritten Transistors (IT2) verbunden ist, wobei eine Anode der dritten Diode (D2) mit der Basis (612) des zweiten Transistors (IT1) gekoppelt ist.

6. Die Einrichtung nach Anspruch 5, wobei eine Schwellenspannung der zweiten Diode (D3) gleich einer Schwellenspannung einer Basis-Emitter-Diode des ersten Transistors (606) ist.

7. Die Einrichtung nach Anspruch 5 oder 6, wobei eine maximale Spannung über dem Kondensator (C1) wenigstens teilweise durch eine Schwellenspannung der dritten Diode (D2) bestimmt wird.

8. Die Einrichtung nach einem der Ansprüche 5 bis 7:
wobei der erste Schwellenwert wenigstens teilweise durch eine Schwellenspannung der ersten Diode (D1) bestimmt wird; oder
wobei die Schaltung (CTRL) eine Diode (D4), vorzugsweise eine ZenerDiode, aufweist, die in Reihe mit dem ersten Widerstand (R1) zwischen dem ersten Anschluss (602) und der Basis (614) des ersten Transistors (606) verbunden ist, wobei der erste Schwellenwert wenigstens teilweise durch eine Rückwärtsleitungs-Schwellenspannung der Diode (D4) bestimmt wird.

9. Die Einrichtung nach einem der Ansprüche 5 bis 8, wobei der zweite Schwellenwert wenigstens teilweise durch eine Schwellenspannung der dritten Diode (D2) und/oder durch eine Schwellenspannung der steuerbaren Diode (10) bestimmt wird.

10. Die Einrichtung nach einem der Ansprüche 5 bis 9:
wobei der dritte Schwellenwert wenigstens teilweise durch die Schwellenspannung der dritten Diode (D2) bestimmt wird; oder
wobei die Schaltung (CTRL) ferner eine Diode (D5) in Reihe mit einem dritten Widerstand (R3) zwischen dem ersten Anschluss (602) und der Basis (614) des dritten Transistors (IT2) aufweist, wobei der dritte Schwellenwert wenigstens teilweise durch eine Schwellenspannung dieser Diode (D5) bestimmt wird.

11. Die Einrichtung nach einem der Ansprüche 5 bis 10:
wobei die Schaltung (CTRL) ferner einen Widerstand (R4) aufweist, der zwischen der Basis (614) des dritten Transistors (IT2) und dem zweiten Anschluss (600) verbunden ist; und/oder
wobei die Schaltung (CTRL) eine Diode (D6) zum Entsättigen des dritten Transistors (IT2) aufweist, die zwischen der Basis (614) und dem Kollektor des dritten Transistors (IT2) verbunden ist.

12. Die Einrichtung nach einem der Ansprüche 1 bis 11, die eine Induktivität (L) aufweist, die einen Anschluss hat, der mit dem zweiten Anschluss (600) verbunden ist, und einen weiteren Anschluss hat, der zum Koppeln mit der Anode der steuerbaren Diode (10) vorgesehen ist.

13. Die Einrichtung nach einem der Ansprüche 1 bis 12, wobei die steuerbare Diode (10) eine OFT-Diode ist, die eine Vielzahl von Strukturen (30A, 30) aufweist, die jeweils in einem Graben (22) eines Substrats (20) eine erste leitfähige Region (302), die von dem Substrat (20) durch einen ersten Abstand (d) von weniger als ungefähr 10 nm getrennt ist, und eine zweite leitfähige Region (306) aufweisen, die in dem Graben (22) tiefer als die erste Region (302) verläuft, wobei die Diode (10) durch einen oder eine Vielzahl von Transistoren (T1) definiert ist, die wenigstens eine Kanalregion (202) haben, die sich zwischen zwei der Gräben (22) erstreckt, wobei die ersten leitfähigen Regionen (302) die Gates der Transistoren (T1) und ein Gate (G) der Diode (10) definieren.

14. Ein Dipol (7), der Folgendes aufweist:
die Einrichtung (6) nach einem der Ansprüche 1 bis 13, wobei der erste Anschluss (602) der Einrichtung eine Kathode (702) des Dipols definiert und der zweite Anschluss (600) der Einrichtung (6) eine Anode (700) des Dipols definiert; und
eine steuerbare Diode (10), vorzugsweise eine OFT-Diode, die eine Kathode (K), die mit dem ersten Anschluss (602) der Einrichtung (6) verbunden ist, eine Anode (A), die mit dem zweiten Anschluss (600) der Einrichtung (6) gekoppelt ist, und ein Gate (G), das mit dem dritten Anschluss (604) der Einrichtung (6) verbunden ist, hat.

15. Ein Schaltnetzteil, das die Einrichtung nach einem der Ansprüche 1 bis 13 oder den Dipol (7) nach Anspruch 14 aufweist.

## Claims

1. A device (6) comprising:
a controllable current source (606) connected between a first node (608) and a first terminal (602) intended to be coupled to a cathode (K) of a controllable diode (10);
a capacitor (C1) connected between the first node (608) and a second terminal (600) intended to be coupled to an anode (A) of the controllable diode (10);
a first switch (IT1) connected between the first node (608) and a third terminal (604) intended to be coupled to a gate (G) of the controllable diode (10);
a second switch (IT2) connected between the second (600) and third (604) terminals; and
a first diode (D1) connected between the third terminal (604) and the second terminal (600), an anode of the first diode (D1) being coupled to the third terminal (604).

2. The device according to claim 1, comprising a circuit (CTRL) configured to control the current source (606), the first switch (IT1), and the second switch (IT2) based on a potential difference between the first (602) and second (600) terminals.

3. The device according to claim 2, wherein the circuit (CTRL) is configured to:
control a delivery of a current (I) to the capacitor (C1) from said source (606) when said potential difference is smaller than a first threshold, preferably negative or zero;
controlling the first switch (IT1) to the on state when said potential difference is greater than a second threshold, preferably positive or zero; and
controlling the second switch (IT2) to the on state when said potential difference is lower than a third threshold, preferably negative or zero.

4. The device according to claim 3, wherein:
the current source (606) is a first NPN-type bipolar transistor having an emitter coupled to the first node (608) and a collector coupled to the first terminal (602);
the first switch (IT1) is a second PNP-type bipolar transistor, having an emitter coupled to the first node (608) and a collector coupled to the third terminal (604); and
the second switch (IT2) is a third NPN-type bipolar transistor having an emitter coupled to the second terminal (600) and a collector coupled to the third terminal (604).

5. The device according to claim 4, wherein said circuit (CTRL) comprises:
a first resistor (R1) coupling the first terminal (602) to a base (610) of the first transistor (606);
a second resistor (R2) coupling the first terminal (612) to a base (612) of the second transistor (IT1);
a second diode (D3) connected between the base (610) of the first transistor (606) and the base (612) of the second transistor (IT1), an anode of the second diode (D3) being coupled to the base (610) of the first transistor (606); and
a third diode (D2) connected between the base (612) of the second transistor (IT1) and a base (614) of the third transistor (IT2), an anode of the third diode (D2) being coupled to the base (612) of the second transistor (IT1) .

6. The device according to claim 5, wherein a threshold voltage of the second diode (D3) is equal to a threshold voltage of a base-emitter diode of the first transistor (606).

7. The device according to claim 5 or 6, wherein a maximum voltage across the capacitor (C1) is at least partly determined by a threshold voltage of the third diode (D2).

8. The device according to any of claims 5 to 7:
wherein the first threshold is at least partly determined by a threshold voltage of the first diode (D1); or
wherein said circuit (CTRL) comprises a diode (D4), preferably a Zener diode, series-connected with the first resistor (R1) between the first terminal (602) and the base (614) of the first transistor (606), the first threshold being at least partially determined by a reverse conduction threshold voltage of said diode (D4).

9. The device according to any of claims 5 to 8 wherein the second threshold is at least partly determined by a threshold voltage of the third diode (D2) and/or by a threshold voltage of the controllable diode (10).

10. The device according to any of claims 5 to 9:
wherein the third threshold is at last partly determined by the threshold voltage of the third diode (D2); or
wherein the circuit (CTRL) further comprises a diode (D5) in series with a third resistor (R3) between the first terminal (602) and the base (614) of the third transistor (IT2), the third threshold being at least partly determined by a threshold voltage of said diode (D5).

11. The device according to any of claims 5 to 10:
wherein the circuit (CTRL) further comprises a resistor (R4) connected between the base (614) of the third transistor (IT2) and the second terminal (600); and/or
wherein the circuit (CTRL) comprises a diode (D6) for desaturating the third transistor (IT2), connected between the base (614) and the collector of the third transistor (IT2).

12. The device according to any of claims 1 to 11, comprising an inductance (L) having a terminal connected to the second terminal (600) and having another terminal intended to be coupled to the anode of the controllable diode (10).

13. The device according to any of claims 1 to 12, wherein the controllable diode (10) is an OFT diode comprising a plurality of structures (30A, 30) each comprising, in a trench (22) of a substrate (20), a first conductive region (302) separated from the substrate (20) by a first distance (d) shorter than approximately 10 nm, and a second conductive region (306) extending in the trench (22) deeper than the first region (302), the diode (10) being defined by one or a plurality of transistors (T1) having at least a channel region (202) extending between two of the trenches (22), the first conductive regions (302) defining the gates of the transistors (T1) and a gate (G) of the diode (10).

14. A dipole (7) comprising:
the device (6) according to any of claims 1 to 13, the first terminal (602) of the device defining a cathode (702) of the dipole and the second terminal (600) of said device (6) defining an anode (700) of the dipole; and
a controllable diode (10), preferably an OFT diode, having a cathode (K) connected to the first terminal (602) of the device (6), an anode (A) coupled to the second terminal (600) of the device (6), and a gate (G) connected to the third terminal (604) of the device (6).

15. A switched-mode power supply comprising the device according to any of claims 1 to 13 or the dipole (7) according to claim 14.
